# EUROPÄISCHE PATENTANMELDUNG

(11) **EP 1 291 929 A1**
(43) Veröffentlichungstag der Anmeldung: **12.03.2003**
(21) Anmeldenummer: 02405762.2
(22) Anmeldetag: 04.09.2002
(51) Int. Cl.: H01L 31/18, H01L 31/05

(54) **Verfahren zur Herstellung eines Solarzellenbands**

(30) Priorität: 11.09.2001 CH 16742001
(71) Anmelder: Strela Gmbh, 4118 Rodersdorf (CH)
(72) Erfinder: Strebel, Beat, 4118 Riodersdorf (CH); Lay, Arthur, 4118 Rodersdorf (CH)
(74) Vertreter: Bollhalder, Renato

(57) **Zusammenfassung**

Bei einem Verfahren zur Herstellung eines Solarzellenbands aus mehreren aneinandergereihten, mit Lötbändern elektrisch und mechanisch verbundenen Solarzellen werden mehrere Solarzellen aneinandergereiht und an die Solarzellen diese verbindende, mit Lot überzogene Lötbänder gelötet. Die Solarzellen und Lötbänder werden gemeinsam in mehreren nacheinander angeordneten Heizmodulen (2) bis auf eine Temperatur im Bereich des Schmelzpunkts des Lots vorgeheizt. Anschliessend wird mit Lötstempeln (10) das Lot zum Schmelzen gebracht und mit einem Niederhalter (13) abgekühlt.

## Beschreibung

Die vorliegende Erfindung bezieht sich auf ein Verfahren zur Herstellung eines Solarzellenbands, wie es im Oberbegriff des unabhängigen Patentanspruchs 1 definiert ist. Mit solch einem Verfahren können elektrisch leitende Lötbänder an Solarzellen gelötet werden, wodurch mehrere Solarzellen durch Lötbänder mechanisch und elektrisch zu einem Band (String) verbunden werden.

Die Herstellung eines Solarmoduls mit einer Vielzahl von Solarzellen erfolgt in mehreren Schritten. Ein erster Schritt ist die Herstellung eines Bandes von mehreren Solarzellen, welche mit lötfähigen und elektrisch leitenden Lötbändern verbunden sind. Die Herstellung dieses Solarzellenbands (String) erfolgt mittels manuellen, halb- oder vollautomatischen Montage- und Lötautomaten. Um eine mechanisch und elektrisch zuverlässige Verbindung zwischen einer Solarzelle und einem daran angesetzten Lötband zu erreichen, muss sowohl die Solarzelle als auch das mit einem Blei-Zinn-Lot überzogene Lötband auf die Schmelztemperatur des Lots gebracht werden.

Oft wird bei den heutigen halb- oder vollautomatischen Montage- und Lötautomaten zum Aufheizen der Solarzellen und Lötbänder auf Löttemperatur mit einer kurzen, einstufigen Vorwärmung von unten her und zum Verlöten mit einer von oben wirkenden Zusatzwärmequelle in Form von Quarzstrahlern gearbeitet. Bei kostengünstigen Systemen wird sogar oftmals auf die Vorwärmung von unten verzichtet.

Da der Temperaturanstieg in den Solarzellen 5 K/Sekunde nicht übersteigen sollte, eignen sich diese Systeme nicht für einen hohen Fertigungsdurchsatz. Bei zu schneller Aufheizung einer Solarzelle steigt die Gefahr von Brüchen und Haarrissen durch die unterschiedliche Temperaturverteilung innerhalb der Solarzelle. Bei Verwendung von Quarzstrahlern als Zusatzwärmequelle ist eine Temperaturregulierung nur sehr schwer und nur mit grossen Toleranzen realisierbar. Dies kann zu Brüchen oder zu Ausschuppungen durch Überhitzen der Solarzellen führen.

Angesichts der Nachteile der bisher bekannten, oben beschriebenen Verfahren und Vorrichtungen liegt der Erfindung die folgende Aufgabe zugrunde. Zu schaffen sind ein Verfahren und eine Vorrichtung zur Herstellung eines Solarzellenbands, mit welchen Lötbänder schneller an Solarzellen gelötet werden können und/oder die Quote der durch das Löten beschädigten Solarzellen verringert werden kann.

Diese Aufgabe wird durch das erfindungsgemässe Verfahren und die erfindungsgemässe Vorrichtung gelöst, wie sie in den unabhängigen Patentansprüchen 1 und 7 definiert sind. Bevorzugte Ausführungsvarianten ergeben sich aus den abhängigen Patentansprüchen.

Das Wesen der Erfindung besteht im Folgenden: Bei einem Verfahren zur Herstellung eines. Solarzellenbands aus mehreren aneinandergereihten, mit Lötbändern elektrisch und mechanisch verbundenen Solarzellen werden mehrere Solarzellen aneinandergereiht und an die Solarzellen diese verbindende, mit Lot überzogene Lötbänder angesetzt. Die Solarzellen und Lötbänder werden gemeinsam in mindestens zwei nacheinander angeordneten Heizmodulen vorgeheizt. Anschliessend wird mit einem Lötstempel das Lot zum Schmelzen gebracht, wodurch die Lötbänder auf die Solarzellen gelötet werden.

Die mindestens zwei, vorzugsweise mindestens vier hintereinander geschalteten Heizmodule bilden die Vorheizstrecke und ermöglichen eine genauere Regelung der Temperatur der Solarzellen als ein einziges Heizmodul, da sie einzeln geregelt werden können. Zu diesem Zweck weisen sie vorzugsweise jeweils einen eigenen Temperaturfühler auf, der eine Temperaturüberwachung ermöglicht. Die vorzugsweise auf der Unterseite der Solarzellen angeordneten Heizmodule erlauben eine gleichmässige Erwärmung der Solarzellen auch bei hohem Systemdurchsatz, d.h. bei hoher Herstellungsgeschwindigkeit. Ausserdem können verschiedene Vorheizprofile eingestellt und exakt reproduziert werden. Die Solarzellen und die Lötbänder können durch die genauere Temperaturregelung mit einem kleineren Schwankungsbereich bis auf eine Temperatur vorgeheizt werden, die höchstens ± 20 K, insbesondere höchstens ± 10 K, vom Schmelzpunkt des Lots abweicht.

Die Länge der Vorheizstrecke, d.h. insbesondere die Anzahl der Heizmodule, errechnet sich aus dem Durchsatz und der Grösse der Solarzellen. Das Aufheizen der Solarzellen soll im Normalfall eine Geschwindigkeit von 5 K/s nicht übersteigen, um Beschädigungen zu vermeiden.

Das Schmelzen des Lots, vorzugsweise eines Blei-Zinn-Lots, wird durch mindestens einen Lötstempel bewirkt, der auf die mit Lot überzogenen Lötbänder aufgesetzt wird. Der Lötstempel ist mit einer Heizung und vorzugsweise einem Temperaturfühler versehen, der eine Temperaturüberwachung zur Regelung der Heizung ermöglicht.

Der Lötstempel ist vorzugsweise lötseitig, d.h. dem Lötband zugewandt, kammartig ausgelegt und federnd aufgehängt, was beim Absenken eine gute Positionierung auf dem darunter liegenden Lötband bewirkt. Durch Aneinanderreihen mehrerer solcher Lötstempel können Solarzellen unterschiedlicher Grösse, beispielsweise von 50 bis 200 mm, optimal gelötet werden. Jeder dieser Lötstempel ist mit einer eigenen Heizung und einer Temperaturregelung ausgestattet. Nach dem Absenken der Lötstempel kann die zu übertragende Wärmemenge exakt dosiert werden, womit ein Überhitzen oder Verbrennen (Ausschuppen) der Lötstellen zuverlässig verhindert wird.

Neben dem oder den Lötstempeln weist der Lötkopf mit Vorteil noch einen Niederhalter auf, der unabhängig von diesen verstellbar ist und als Abkühler wirkt. Nach der Lötung wird der Niederhalter abgesenkt und der oder die Lötstempel zurückgezogen, d.h. heisst vom betreffenden Lötband abgehoben. Der Niederhalter kann sowohl als einfacher, passiver Niederhalter als auch als aktiver Kühlstempel ausgebildet sein, der beispielsweise Kühlkanäle zur Kühlung mit Luft oder Wasser aufweist. Durch den Lötkopf kann sowohl die Lötung wie auch die anschliessende Abkühlung genau kontrolliert werden.

Für den Transport der Solarzellen und Lötbänder von einem Heizmodul zum nächsten und schliesslich zu dem oder den Lötstempeln ist eine Transportvorrichtung vorgesehen, die vorzugsweise ein angetriebenes Transportband umfasst, wobei das Transportband beispielsweise mit einem Karbid oder Nitrid, insbesondere Wolframkarbid oder Titannitrid, beschichtet ist.

Im Folgenden werden das erfindungsgemässe Verfahren und die erfindungsgemässe Vorrichtung anhand der beiliegenden Zeichnungen zweier Ausführungsbeispiele erläutert. Es zeigen:
- Fig. 1: eine schematische Seitenansicht einer erfindungsgemässen Lötvorrichtung mit Transportband, Antriebsrollen. Vorheizstrecke und Lötköpfen gemäss einem ersten Ausführungsbeispiel;
- Fig. 2 -: die Lötköpfe der Vorrichtung von Fig. 1 mit Lötstempeln und Niederhaltern über dem Transportband in Lötrichtung gesehen;
- Fig. 3 -: eine Seitenansicht eines der Lötköpfe gemäss Pfeil A in Fig. 2, wobei aus Übersichtlichkeitsgründen der Niederhalter nicht gezeichnet ist;
- Fig. 4 -: den Niederhalter eines der Lötköpfe von Fig. 2;
- Fig. 5 -: erfindungsgemässe Lötköpfe gemäss einem zweiten Ausführungsbeispiel mit Lötstempeln und Niederhaltern in Form von Kühlstempeln über einem Transportband in Lötrichtung gesehen; und
- Fig. 6 -: eine Seitenansicht der Kühlstempel eines der Lötköpfe von Fig. 5, wobei aus Übersichtlichkeitsgründen die Lötstempel nicht gezeichnet sind.

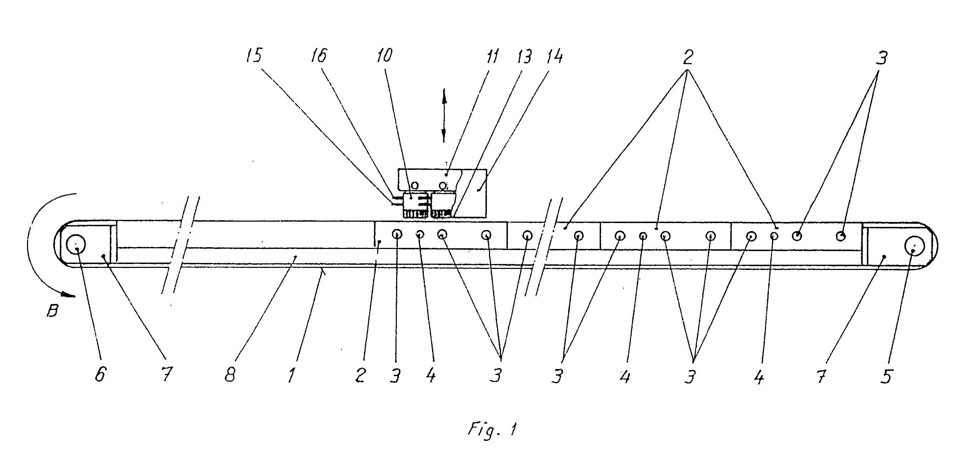

Fig. 1 zeigt ein gelochtes und mit einer Antihaftbeschichtung, z.B. aus Teflon oder einem Karbid oder Nitrid, insbesondere Wolframkarbid oder Titannitrid, überzogenes Transportband 1, auf welchem sowohl die Solarzellen als auch die Lötbänder abgelegt werden. Das Transportband 1 läuft über mehrere mit Vakuumkanälen ausgerüstete Heizmodule 2, wobei die Vakuumkanäle zum Transportband 1 hin offen sind. Mittels einer Vakuumpumpe wird in den Vakuumkanälen ein Unterdruck erzeugt, durch den die Lötbänder und Solarzellen auf dem Transportband 1 gehalten werden. Das Transportband 1 wird über Umlenk-/Spannrollen 5 und Antriebsrollen 6 geführt und in Richtung des Pfeils B taktweise vorgeschoben. Die Umlenk-/Spannrollen 5 und Antriebsrollen 6 sind von Lagerköpfen 7 aufgenommen, die an einem Maschinenrahmen 8 angebracht sind.

Die Heizmodule 2 umfassen jeweils drei Heizungen 3 zum Aufheizen der Solarzellen und Lötbänder. Mittels eines Temperaturfühlers 4 pro Heizmodul 2 kann die Temperatur der Heizmodule 2 bzw. der Solarzellen und Lötbänder überwacht und jedes der Heizmodule 2 einzeln geregelt werden.

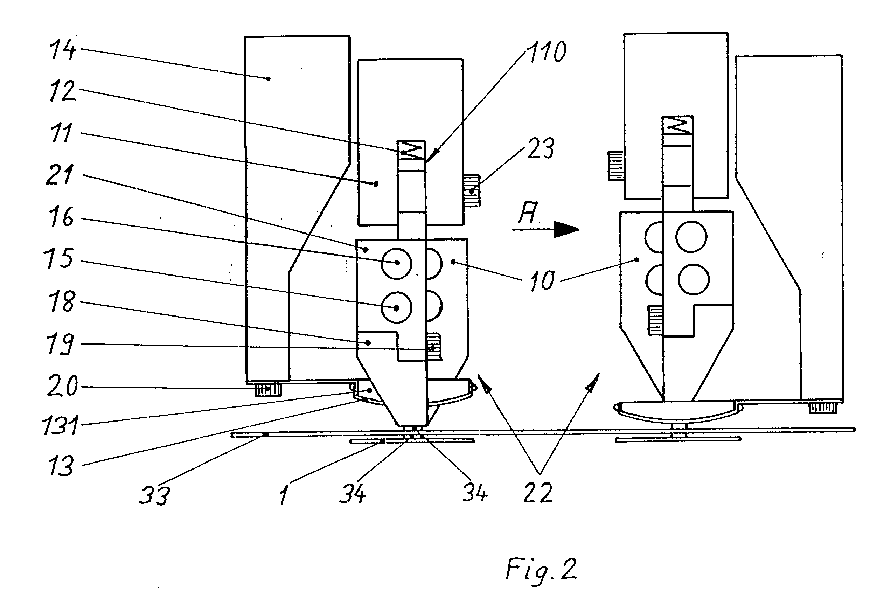

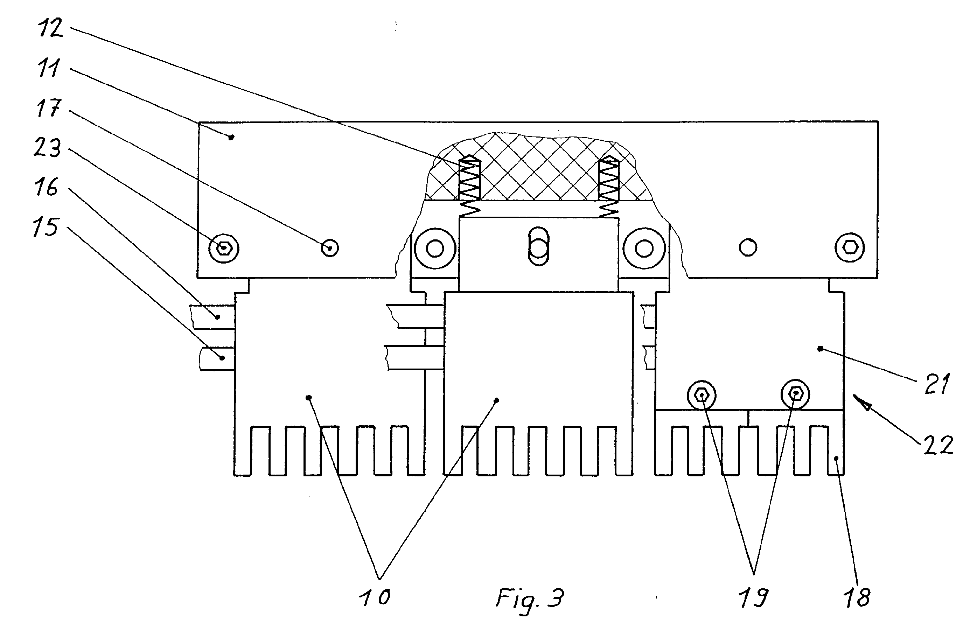

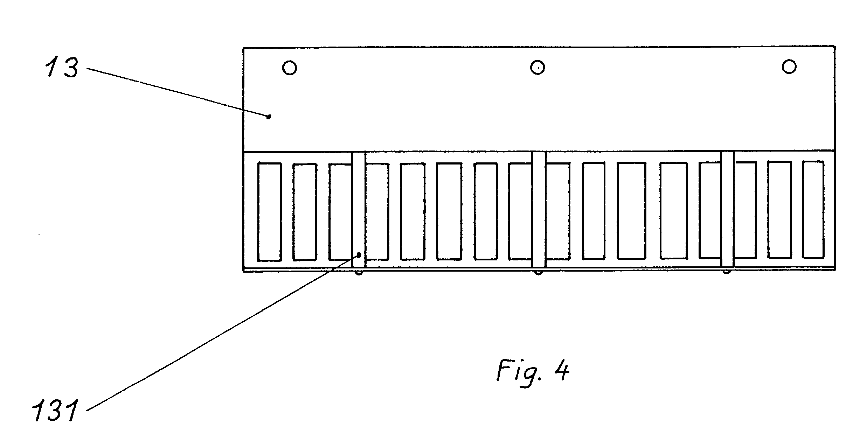

Oberhalb des letzten Heizmoduls 2 sind zwei Lötköpfe angeordnet, die in den Fig. 2 bis 4 detaillierter dargestellt sind. Dass, wie aus Fig. 2 ersichtlich, zwei Lötköpfe nebeneinander angeordnet sind, bezweckt, dass zwei Lötbänder 34 gleichzeitig nebeneinander auf oder unter Solarzellen 33 gelötet werden können. Zur Verdeutlichung der Funktion ist der linke Lötkopf in Fig. 2 in der Lötstellung dargestellt, während der rechte Lötkopf in der Abkühlstellung gezeichnet ist. In Wirklichkeit befinden sich beide Lötköpfe normalerweise in derselben Stellung.

Die Lötköpfe, die am Maschinenrahmen 8 befestigt sind, umfassen als wesentliche Elemente jeweils zwei einteilige Lötstempel 10, einen mehrteiligen Lötstempel 22 und einen Niederhalter 13.

Die einteiligen Lötstempel 10 sind lötseitig kammartig ausgeführt. Die Lötstempel 22 umfassen jeweils zwei Kammteile 18, die jeweils mittels einer Schraube 19 an einen Lötgrundstempel 21 geschraubt sind. Die Anpassung der Gesamtlänge der Kammbereiche aller Lötstempel eines Lötkopfs kann durch Anbringen oder Entfernen von Kammteilen 18 der Lötstempel 22 und/oder ganzer Lötstempel 10 vorgenommen werden, so dass die Länge der Lötung insbesondere auf die Grösse der Solarzellen 33 angepasst werden kann. Auf diese Weise können mit derselben Vorrichtung Solarzellen 33 unterschiedlicher Grösse, z.B. 2, 3, 4, 5, 6, 7 oder 8 Zoll, gelötet werden.

Die Kammbereiche der Lötstempel 10 und Kammteile 18 der Lötstempel 22 sind mit einer Antihaftbeschichtung, z.B. aus Teflon oder einem Karbid oder Nitrid, insbesondere Wolframkarbid oder Titannitrid, überzogen. Pro Lötstempel 10, 22 sind zwei schräggestellte Bohrungen für die Aufnahme einerseits eines Temperaturfühlers 15 und anderseits einer Heizung 16 vorgesehen. Der Temperaturfühler 15 ermöglicht eine präzise Regelung der Heizung 16, was übermässige Temperaturen verhindert. Die Lötstempel 10, 22 werden in eine Schlitzführung 110 eines Halters 11 eingesetzt und jeweils von einem Bolzen 17 gehalten. Mittels Distanzhalterschrauben 23 wird die Schlitzbreite der Schlitzführung 110 konstant gehalten, was es ermöglicht, den Halter 11 aus Kunststoff zu fabrizieren. Mit Federn 12 werden die Lötstempel 10, 22 zentriert und federnd aufgehängt, so dass sie sich beim Löten in ihrer Lage wie auch in ihrer Höhe an die Solarzellen 33 anpassen können.

Der Niederhalter 13 umfasst ein federndes, beschichtetes, z.B. mit Teflon oder einem Karbid oder Nitrid, insbesondere Wolframkarbid oder Titannitrid, und sich in den Lücken des Lötkamms bewegendes Blech, das mit Schrauben 20 an einem Halter 14 befestigt ist. Der Niederhalter 13 wirkt nach dem Absenken auf das darunter liegende Lötband 34 als passives Kühlelement. Er wird in seiner Bewegung durch die Lötstempel 10 oder Kammteile 18 geführt, wobei durch in das Blech eingepresste und aus diesem nach oben vorstehende Stege 131 sichergestellt wird, dass beim Absenken die Führung durch die Lötstempel 10 und Kammteile 18 nicht verloren geht.

Das Absenken und Anheben der Lötstempel 10, 22 und der Niederhalter 13 erfolgt durch separate pneumatische oder elektrische Antriebe. Prinzipiell werden zunächst zum Schmelzen des Lots die Lötstempel 10, 22 auf die darunter liegenden Lötbänder 34 abgesenkt. Nach dem Schmelzen werden die Niederhalter 13 auf die Lötbänder 34 abgesenkt und die Lötstempel 10, 22 werden wieder angehoben.

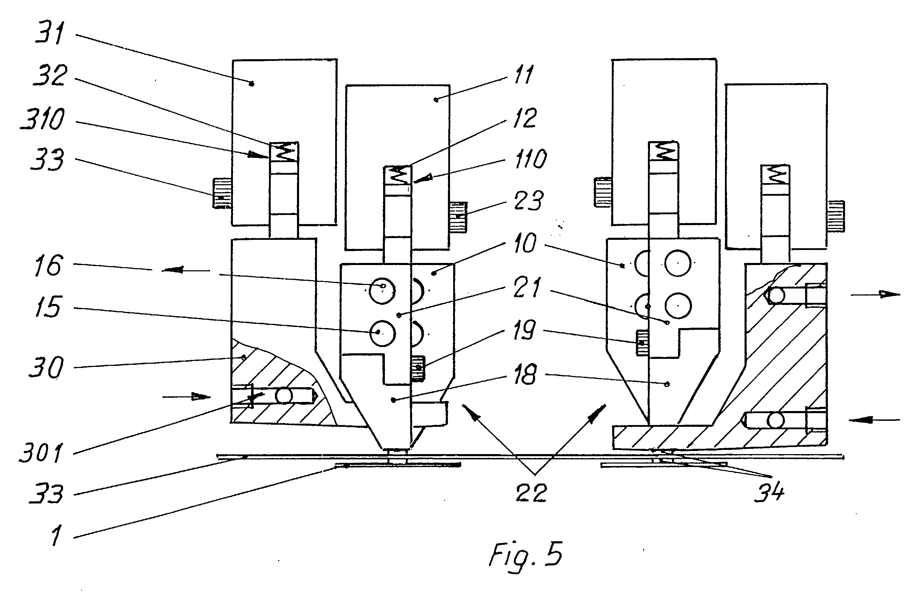

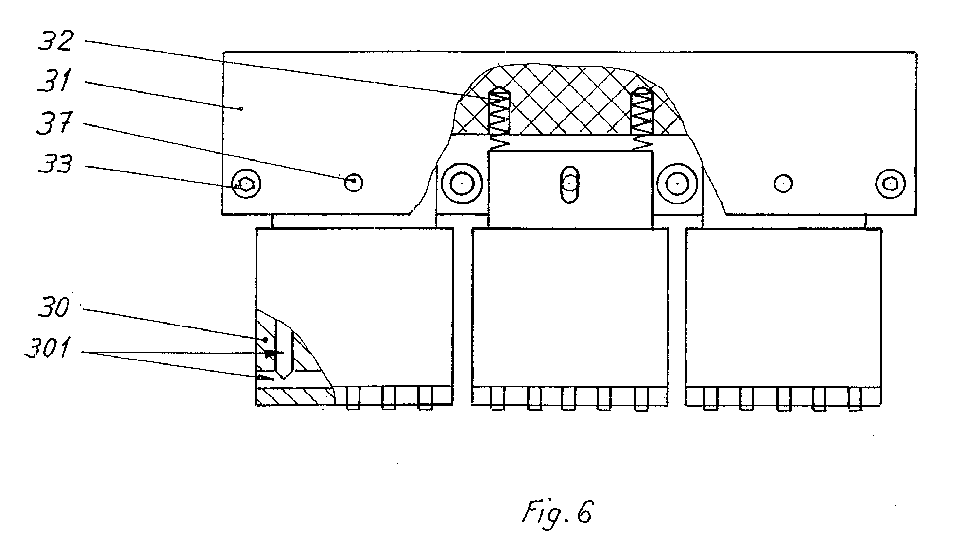

Bei dem in den Fig. 5 und 6 dargestellten zweiten Ausführungsbeispiel sind anstelle der als passive Kühlelemente wirkenden Niederhalter 13 jeweils drei aktive Kühlstempel 30 vorhanden. Zur Verdeutlichung der Funktion ist wiederum der linke Lötkopf in Fig. 5 in der Lötstellung dargestellt, während der rechte Lötkopf in der Abkühlstellung gezeichnet ist, obwohl sich die beiden Lötköpfe normalerweise in derselben Stellung befinden. Der Aufbau und die Funktion der Lötvorrichtung gemäss dem zweiten Ausführungsbeispiel entspricht bis auf die Kühlstempel 30 bzw. Niederhalter 13 dem Aufbau und der Funktion der Lötvorrichtung gemäss dem ersten Ausführungsbeispiel und es wird daher für die entsprechenden Teile auf die diesbezügliche Beschreibung verwiesen.

Die Kühlstempel 30 sind Teil eines aktiven Abkühl-/Niederhaltermoduls. Sie sind L-förmig ausgebildet, im Lötbereich mit einer Antihaftbeschichtung, z.B. aus Teflon oder einem Karbid oder Nitrid, insbesondere Wolframkarbid oder Titannitrid, versehen und laufen in den Lücken des Kammbereichsder Lötstempel 10, 22. In den Kühlstempeln 30 sind Kühlkanäle 301, insbesondere Bohrungen, angeordnet, die mit Luft oder Wasser durchströmt werden können, womit eine Kühlung bewirkt werden kann. Diese Kühlstempel 30 sind entsprechend den Lötstempeln 10, 22 in eine Schlitzführung 310 eines Halters 31 eingesetzt und jeweils von einem Bolzen 37 gehalten. Mittels Distanzhalterschrauben 33 wird die Schlitzbreite der Schlitzführung 310 konstant gehalten, was es ermöglicht, den Halter 31 aus Kunststoff zu fabrizieren. Mit Federn 32 werden die Kühlstempel 30 zentriert und federnd aufgehängt, so dass sie sich beim Aufsetzen auf die Lötbänder 34 in ihrer Lage wie auch in ihrer Höhe anpassen können.

Auch bei diesem Ausführungsbeispiel werden die Kühlstempel 30 und die Lötstempel 10, 22 separat mittels pneumatischen oder elektrischen Antrieben verstellt.

Zu den oben beschriebenen Ausführungsbeispielen sind im Rahmen der Erfindung verschiedene Variationen denkbar. Beispielsweise können die Lötköpfe jeweils auch nur einen Lötstempel umfassen.

## Patentansprüche

1. Verfahren zur Herstellung eines Solarzellenbands aus mehreren aneinandergereihten, mit Lötbändern (34) elektrisch und mechanisch verbundenen Solarzellen (33), bei dem mehrere Solarzellen (33) aneinandergereiht und an die Solarzellen (33) diese verbindende, mit Lot überzogene Lötbänder (34) gelötet werden, **dadurch gekennzeichnet, dass** die Solarzellen (33) und Lötbänder (34) gemeinsam in mindestens zwei nacheinander angeordneten Heizmodulen (2) vorgeheizt werden und anschliessend mit einem Lötstempel (10, 22) das Lot zum Schmelzen gebracht wird.

2. Verfahren nach Anspruch 1, **dadurch gekennzeichnet, dass** die Solarzellen (33) und Lötbänder (34) bis auf eine Temperatur vorgeheizt werden, die höchstens ± 20 K, insbesondere höchstens ± 10 K, vom Schmelzpunkt des Lots abweicht.

3. Verfahren nach Anspruch 1 oder 2, **dadurch gekennzeichnet, dass** beim Vorheizen die Erhöhung der Temperatur der Solarzellen (33) und Lötbänder (34) mit höchstens 5 K/s erfolgt.

4. Verfahren nach einem der Ansprüche 1 bis 3, **dadurch gekennzeichnet, dass** die Wärmezufuhr beim Vorheizen und beim Schmelzen des Lots mit Temperaturfühlern (4, 15) überwacht und geregelt wird.

5. Verfahren nach einem der Ansprüche 1 bis 4, **dadurch gekennzeichnet, dass** nach dem Schmelzen des Lots das Lot, die Lötbänder (34) und die Solarzellen (33) mit passiven Kühlelementen (13) abgekühlt werden.

6. Verfahren nach einem der Ansprüche 1 bis 4, **dadurch gekennzeichnet, dass** nach dem Schmelzen des Lots das Lot, die Lötbänder (34) und die Solarzellen (33) mit Kühlmitteln, insbesondere einem Kühlstempel (30), aktiv abgekühlt werden.

7. Vorrichtung zur Durchführung des Verfahrens nach einem der Ansprüche 1 bis 6, mit einer Vorheizstrecke zum Vorheizen von Solarzellen (33) und mit Lot überzogenen Lötbändern (34) sowie einer Schmelzwärmequelle zum anschliessenden Schmelzen des Lots, **dadurch gekennzeichnet, dass** die Vorheizstrecke mindestens zwei nacheinander angeordnete Heizmodule (2) und die Schmelzwärmequelle einen Lötstempel (10, 22) umfasst.

8. Vorrichtung nach Anspruch 7, **dadurch gekennzeichnet, dass** sie ein Transportband (1) zum Transportieren der Solarzellen (33) und Lötbänder (34) von einem Heizmodul (2) zum nächsten und schliesslich zum Lötstempel (10, 22) aufweist, wobei das Transportband (1) mit einem Karbid oder Nitrid, insbesondere Wolframkarbid oder Titannitrid, beschichtet ist.

9. Vorrichtung nach Anspruch 7 oder 8, **dadurch gekennzeichnet, dass** die Schmelzwärmequelle zwei oder mehr hintereinander angeordnete Lötstempel (10, 22) mit Heizungen (16) umfasst, die vorzugsweise lötseitig kammartig ausgebildet sind.

10. Vorrichtung nach einem der Ansprüche 7 bis 9, **dadurch gekennzeichnet, dass** der oder die Lötstempel (10, 22) vertikal verstellbar sind und mindestens ein auf das Lot absenkbarer Niederhalter (13; 30) vorhanden ist.

11. Vorrichtung nach Anspruch 10, **dadurch gekennzeichnet, dass** der Niederhalter (30) als Kühlstempel (30) mit Kühlkanälen (301) ausgebildet ist.

12. Vorrichtung nach einem der Ansprüche 7 bis 11, **dadurch gekennzeichnet, dass** die Heizmodule (2) und der oder die Lötstempel (10, 22) mit Temperaturfühlern (4, 15) versehen sind.
